(19) Europäisches Patentamt
European Patent Office
Office européen des brevets

(11) Publication number: 0 013 006
B1

(12) **EUROPEAN PATENT SPECIFICATION**

(45) Date of publication of patent specification: 22.06.83

(51) Int. Cl.$^3$: G 03 F 7/02

(21) Application number: 79105296.2

(22) Date of filing: 20.12.79

(54) **Developer composition for lithographic printing plates.**

(30) Priority: 25.12.78 JP 159658/78

(43) Date of publication of application: 09.07.80 Bulletin 80/14

(45) Publication of the grant of the patent: 22.06.83 Bulletin 83/25

(84) Designated Contracting States: DE FR GB NL

(56) References cited:
DE - A - 2 012 390
DE - A - 2 364 631
DE - A - 2 504 130
FR - A - 2 319 923
FR - A - 2 366 598
FR - E - 84 400
JP - A - 59 050 476

CHEMICAL ABSTRACTS, vol. 91, no. 18, October 29, 1979, page 588, abstract 149488b Columbus, Ohio, USA

(73) Proprietor: MITSUBISHI CHEMICAL INDUSTRIES LIMITED
5-2, Marunouchi 2-chome Chiyoda-ku
Tokyo 100 (JP)

(72) Inventor: Shimizu, Shigeki
18-24, Soshigaya 4-chome
Setagaya-ku Tokyo (JP)
Inventor: Ide, Hiroshi
1721, Ichigao-cho, Midori-ku
Yokohama-shi, Kanagawa-ken (JP)

(74) Representative: Weinhold, Peter, Dr. et al,
Patentanwälte Dipl.-Ing. P. Wirth Dr. V. Schmied-Kowarzik Dipl.-Ing. G. Dannenberg Dr. P. Weinhold Dr. D. Gudel Dipl.-Ing. S. Schubert
Siegfriedstr. 8
D-8000 München 40 (DE)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England

EP 0 013 006 B1

# Developer composition for lithographic printing plates.

This invention relates to a developer composition for lithographic printing plates.

Photosensitive polymers of the photo-crosslinkable type have been widely practically used as a photo-etching resist. The photosensitive polymers and polymer compositions of this type are more excellent in characteristics such as sensitivity, stability and image strength, etc. than photosensitive diazo materials which have been heretofore applied as a lithographic printing plate. So, the photo-crosslinkable, photosensitive polymers have been recently used widely in the preparation of lithographic printing plates. The photosensitive polymers crosslink and harden upon exposure to actinic light and become relatively insoluble in solvents as compared with the unexposed polymer. The difference in property between the exposed area and unexposed area is utilized in the photographic preparation of printing plates. That is, the photosensitive polymer is coated on a lithographic support as a layer together with additives such as, for example, sensitizers, colorants, etc., and the plate having such coating layer is exposed to an imagewise pattern of radiation, thereby creating soluble and insoluble areas in the photosensitive layer. Then, the plate is treated with a developer solvent or solution for the unexposed polymer to develop the image by removing the unexposed, unhardened, soluble polymer therefrom.

Since it is advantageous to produce an image which is visible at the time of development, it is usual to incorporate a dye or pigment in the photosensitive layer. In this connection, however, there arises a problem that the proper choice of developer solution is more difficult when these colorants, particularly pigments, are contained. Unless there is a very careful balance of properties in the developer solution, a pigment or dye which is used for coloring the photosensitive layer is left to some extent in the unexposed area upon the development and creates stains by deposition of ink on the unexposed area when the plate is used for printing. Accordingly, the developer solution for the lithographic printing plate using a colored polymer composition is desired to cleanly develop the plate surface without impairing the coating layer in the exposed area so as to remove unwanted portions of the polymer and not to cause a leaching out of the pigment in the exposed area.

A further problem with the clean development of lithographic printing plates of the type having the colored coating of the photosensitive polymer is that plates which have been kept for considerable time before use are less easily developed than freshly prepared plates, i.e. an unusual amount of staining or scumming takes place on older plates. It is desirable, therefore, that the developer solution produces plates without stains and scums not only on fresh plates, but also on aged plates.

In recent years, most of the developments of the lithographic plates are automatized and conducted by the use of automatic developing machines. In this case, the developer solution is in most cases circulated repeatedly for reuse. However, when the developer solution which has been employed in such a way as mentioned above is used over a certain time, it is fatigued and its developing ability is lowered, disabling the lithographic plate from being rapidly, cleanly developed. Accordingly, there is a demand of developer solutions which are low in fatigue speed, excellent in storage stability and capable of stable development over a long time.

French Patent No. 2,319,923 discloses a developer for a lithographic printing plate, comprising diethylene glycol monoethylether, ethylene glycol monobutylether, sulfuric acid and water. German Patent No. 2,504,130 discloses a method for developing a lithographic printing plate at a high temperature by the use of a developer comprising alcohol such as ethylene glycol monophenylether as a component. However, the developers of the prior art references are not satisfactory for good development.

Automatic developing machines are made of rubber parts, plastic parts, metal parts and the like. This may cause problems such as swelling, dissolution of the rubber or plastic parts, or corrosion of the metal parts, depending on the composition of the developer solution. Accordingly, there is a further demand of developer solutions which show the above-mentioned developing performances against the lithographic plate and which do not cause any damage on the individual parts of the automatic developing machine and make it possible to select materials for parts of the machine from such a wide variety of materials as possible.

The developer compositions of the type which have been heretofore known are satisfactory for cleanly developing lithographic printing plates to some extent when they are fresh, but there are hardly known developer compositions which fully satisfy with regard to the stability of the developer solution themselves or with regard to the resistance of materials for the automatic developing machine.

For instance, a developer composition which contains $\gamma$-butyrolactone and an acid present no problems of clean development of lithographic plates when it is fresh, but often gives a strongly offensive odor because $\gamma$-butyrolactone decomposes during storage or its refining condition is unsatisfactory. An intensive study on the storage stability of developer compositions has been made and, as a result, it has been found that the fatigue of the developer solution of the above-mentioned type results greatly from incorporation of water, aside from thermal stabilities of the individual components of the developer solution. Even though care is paid to a prevention of moisture from being incorporated into the developer solution of this type, moisture or water droplets are inevitably absorbed or incorporated

into the developer solution with automatic developing machines since the developer solution in most cases has to be recycled in the case of practical developing operations and particularly with automatic developing machines. Accordingly, there is desired a developer composition which is usable over a long period of time without involving any changes in quality of the developer solution even when a certain amount of water is incorporated. As for the choice of rubber materials for use as rubber parts of the automatic developing machine, the $\gamma$-butyrolactone-base developer solution of the type just mentioned tends to relatively swell chloroprene rubber or silicone rubber of certain types and thus the choice of rubber materials to be used for the automatic developing machines is limited.

In considering the above prior art problems, we have intensively studied and arrived at completion of the present invention.

An object of the present invention is to provide a novel developer composition for lithographic printing plates having a colored layer of a photosensitive polymer which is capable of cleanly, rapidly removing unexposed areas of the colored photosensitive coating without impeding exposed areas of the coating layer.

Another object of the invention is to provide a novel developer composition which is capable of readily developing not only freshly prepared lithographic plates having a photosensitive polymer coating thereon, but also aged ones.

A further object of the invention is to provide a developer composition which shows a slow rate of fatigue when reused by circulation and excellent storage stability, and can realize a stable development over a long time.

A still further object of the invention is to provide a developer composition which shows broad developing latitude by giving a stable developing effect against the change of developing conditions.

A still further object of the invention is to provide a developer composition which shows little or no tendency of damaging most materials usable as parts of automatic developing machines.

The above objects can be achieved by a developer composition for lithographic printing plates of the type which have a coating layer of a photosensitive polymer having in the main chain thereof a group represented by the general formula (I)

$$-(CX{=}CY)_n-\overset{\overset{\displaystyle O}{\|}}{C}-$$

(in which X and Y independently represent a hydrogen atom, a halogen atom, a cyano group or a nitro group, and n is an integer of 1 or 2)

comprising a mono-ether of ethylene glycol, an acid and water

characterized by comprising

from 30 to 60 weight % of

ethylene glycol monophenyl ether as the ethylene glycol ether component

from 0.1 to 10 weight % of

at least one acid selected from the group consisting of mineral acids, organic carboxylic acids and organic sulfonic acids as the acid component

and less than 10 weight % of water in the developer composition.

The present invention will be described in more detail.

Ethylene glycol monophenyl ether is one of the essential components of the developer composition according to the invention. The solvents suitable for the developer composition are preferred to be low in volatility from viewpoints of workability and safety and should preferably have a boiling point above 150°C. Among the solvents having such physical properties as mentioned above, the ethylene glycol monophenyl ether is excellent in solubility of the composition in unexposed areas of the photosensitive polymer having the group represented by the general formula (I), and its dissolving action hardly suffers from the influence of moisture. The latter characteristic is the most important feature in the developer composition of the present invention and this is why the developer composition is stable against incorporation of moisture.

Poor solvents for the polymer composition in unexposed areas may be contained, if necessary, in the developer composition of the invention according to the usual manner, by which the developer composition shows good solvent action on the polymer composition in unexposed areas but is substantially free of swelling the polymer composition in exposed areas, thereby adjusting the dissolving power as not to cause any damage on the exposed areas. The adjustment of such dissolving power leads to a lesser tendency of damaging rubber parts or plastic parts used as materials for the automatic developing machine.

The poor solvents used for the adjustment of the dissolving power include, for example: diethylene glycol monoalkyl ethers such as diethylene glycol monomethyl ether, diethylene glycol monoethyl ether, diethylene glycol monobutyl ether and the like; triethylene glycol monoalkyl ethers such as triethylene glycol monomethyl ether, triethylene glycol monoethyl ether and the like; diethylene glycol monoalkyl ether acetates such as diethylene glycol monomethyl ether acetate, diethylene glycol

monoethyl ether acetate, diethylene glycol monobutyl ether acetate and the like; triethylene glycol monoalkyl ether acetates such as triethylene glycol monomethyl ether acetate, triethylene glycol monoethyl ether acetate and the like; ethylene glycol monoalkyl ether acetates such as ethylene glycol monomethyl ether acetate, ethylene glycol monoethyl ether acetate, ethylene glycol monobutyl ether acetate and the like; ethylene glycol monoalkyl ethers such as ethylene glycol monopropyl ether, ethylene glycol monoisopropyl ether, ethylene glycol monobutyl ether, ethylene glycol monoisobutyl ether and the like; and tetrahydrofurfuryl alcohol.

It is preferable to use poor solvents having high solubility for water. In many cases, water-base agents for desensitizing treatment subsequent to developing treatment are used. When the developer solution has a strong affinity to water, the developer solution can be easily removed from the lithographic plate surface by the water-base desensitizing agent. For this purpose, poor solvents such as ethylene glycol monoalkyl ethers, diethylene glycol monoalkyl ethers, diethylene glycol monoalkyl ethers acetates, and tetrahydrofurfuryl alcohol are preferably used.

The amount of the poor solvent may be in the range of 30—70 wt.-% of the developer composition. Water may be incorporated upon addition of acid components in an amount less than 10 wt.-% of the developer composition.

In order to prevent the formation of scums or stains on the non-image portions of the lithographic plate, it is necessary that the developer composition of the invention contains an acid. Examples of the acid include: mineral acids such as phosphoric acid, sulfuric acid, hydrochloric acid and the like; organic carboxylic acids such as acetic acid, lactic acid, glycolic acid, $\alpha$-pentenoic acid and the like; and organic sulfonic acids such as benzenefulfonic acid, paratoluenesulfonic acid and the like. Hydrochloric acid should preferably be used in an amount as small as possible, since the acid readily attacks metal materials for automatic developing machines. A preferred acid is phosphoric acid.

The amount of the acid in the developer composition is 0.1—10 wt.% of the developer composition. Since the acidic development is preferred, the amount of added acid should be controlled in such a way that the developer composition is rendered acidic, preferably having a pH of about 1—6.

Aside from the above described components, additives such as one or more wetting agents or surface active agents are preferably incorporated in the developer composition. Those are used in order to render the developer solution fed to the lithographic plate a characteristic of easily spreading on the plate surface in good condition and a characteristic of not adhering the polymer pigment once removed from non-image areas to the plate. Examples of wetting or surface active agents include: polyhydric alcohols such as glycerol, diethylene glycol and the like; phosphoric esters of alkanols such as n-hexanol, n-decanol and the like; polyethers such as polyoxyethylene octylphenyl ether, polyoxyethylene oleyl ether and the like; and organic acid esters such as sodium dialkylsuccinate.

In order to improve an ink-depositing tendency on exposed, hardened image areas of a lithographic plate, the presence of one or more oleophilic improvers such as, for example, methyl abietate, ethyl abietate and the like is preferred.

Apart from the above-indicated additives, the developer composition may further contain small amounts of other additives, including, for example, a basic amine or salts thereof such as triethanolamine, or phosphate of triethanolamine so as to prevent formation of stains or scums in non-image areas by effectively removing the photosensitive layer composition therefrom or to prevent the polymer composition in image areas from swelling.

The total amount of additives which can be incorporated in the developer composition preferably is not more than 10 percent by weight of the total amount of the developer composition.

The developer composition according to the invention is effective in treating lithographic plates carrying a coating layer of a photosensitive polymer having the group represented by the general formula (I) in the main chain thereof, e.g. polyester, polycarbonate, polysulfonate and the like. Typical of the photosensitive polymer are polyesters which are readily prepared, for example, by polycondensing polyvalent carboxylic acids or ester derivatives thereof having the group of the general formula (I) in the main chain thereof with polyhydric alcohols according to the usual manner. Examples of such polyvalent carboxylic acids include p-phenylenedi-acrylic acid, p-carboxycinnamic acid, bis(p-carboxybenzal)cyclo-pentanone, bis(p-carboxycinnamoyl)benzene, p,p'-chalconedi-carboxylic acid, fumaric acid, maleic acid and the like. Of these, p-phenylenediacrylic acid is the most preferable one. Other polyvalent carboxylic acids such as succinic acid, adipic acid, terephthalic acid and the like may be used as well as the unsaturated acids.

Examples of the polyhydric alcohols include ethylene glycol, diethylene glycol, triethylene glycol, tetraethylene glycol, propylene glycol, dipropylene glycol, tripropylene glycol, 1,3-propanediol, hydrogenated bisphenol A, hydrogenated bisphenol F, bis($\beta$-hydroxyethoxy)cyclohexane, p,p',dihydroxychalcone and the like. These may be used singly or in combination.

The lithographic plate is usually prepared by applying on a support in a usual manner the photosensitive polymer together with other additives such as, for example, sensitizers, colorants such as phthalocyanine pigment, etc., in the form of a layer. If the phthalocyanine pigment is used, there is obtained a lithographic plate having colored coacting layer thereon.

The supports for the printing plates are metal sheets such as aluminium, mechanically, electrochemically or chemically surface-treated aluminium, copper, zinc, etc. paper sheets, polymer coated

papers, synthetic resin sheets and the like. The most preferable type of lithographic plates for applying the invention is disclosed in European Patent Application 79 103 453.1.

The development using the developer composition of the invention is carried out according to known methods. For instance, the developer solution of the invention is applied to the surface of a lithographic plate which was subjected to an image-wise exposure, and non-exposed areas of the photosensitive polymer composition are removed from the support surface. The removal of the polymer composition from the non-image areas of the lithographic plate is effectively performed by a gentle mechanical action such as wiping of the plate surface.

The present invention will be particularly illustrated by way of the following examples, which should not be construed as limiting the invention thereto.

Example 1

To a 4 wt.% cyclohexanone solution of a photosensitive polyester which had been prepared by condensing 0.4 moles of p-phenylenediacrylic acid with 0.2 moles of hydrogenated bisphenol A and 0.2 moles of triethylene glycol were added 2-dibenzoylmethylene-3-methyl-$\beta$-naphthothiazoline in an amount of 5 wt.% of the polyester, and phthalocyanine pigment in an amount of 20 wt.% of the polyester to obtain a photosensitive solution. The thus obtained photosensitive solution was applied to an electrolyzed aluminium plate having a thickness of 1.0—1.2 $\mu$. The lithographic plate was dried, exposed to light through a negative film, and developed with a developer composition of the following formulation.

| | |
|---|---|
| Ethylene glycol monophenyl ether | 50 wt.% |
| Diethylene glycol monoethyl ether acetate | 20 wt.% |
| Diethylene glycol monoethyl ether | 20 wt.% |
| Water | 5 wt.% |
| 85% Phosphoric acid | 5 wt.% |

In the thus developed printing plate the polymer composition in the exposed, hardened image areas was substantially free of swelling and suffered no damage, and no staining of the pigment in the non-image areas was found. When this plate was used for printing, good copies were obtained without involving stains on the non-image areas.

Example 2

The lightgraphic plate obtained in Example 1 was subjected prior to exposure and development to a force deterioration test for 10 days under conditions of 40°C and a relative humidity of 80%, or under conditions of 55°C and a relative humidity of less than 10%. In general, the thus deteriorated plate is contaminated with stains or scums since the polymer composition is not completely removed from non-exposed areas during development. However, when the developer solution of Example 1 was used to develop the thus deteriorated plates, good development was attained similarly to the case of Example 1, and occurrence of stains or scums on the non-image areas was not found in the printing test thereby giving good printings.

Comparative Example 1

A developer composition of the following formulation containing $\gamma$-butyrolactone and an acid was prepared for comparative purposes.

| | |
|---|---|
| $\gamma$-butyrolactone | 84 wt.% |
| $\gamma$-hydroxybutyric acid | 3 wt.% |
| Phosphoric acid | 3 wt.% |
| Water | 5 wt.% |
| Glycerine | 5 wt.% |

This $\gamma$-butyrolactone-base developer solution was used to develop lithographic plates under conditions similar to those of Examples 1 and 2, with good developing results. However, when 3% of water was added to the developer solution of this Comparative Example and the developer composition of Example 1, respectively, and then lithographic plates were developed with these developer solutions similarly to Example 1, the unexposed polymer composition was not effectively removed and left in the

developer solution of Comparative Example 1.

Using the developer composition of Example 1, a good developing effect was obtained without any inconvenience.

Example 3

Rubber materials which are used as rubber parts of an automatic developing machine were immersed in the developer composition of Example 1 and the developer solution of Comparative Example 1, respectively, and allowed to stand for 3 weeks at 50°C to determine weight changes of the rubber materials. The results are shown in Table 1 below.

TABLE 1

| | Developer solution of Example 1 | Developer solution of Comparative Example |
|---|---|---|
| Chloroprene rubber | −1% | +17% |
| Soft silicone rubber | +2.5% | −14.5% |
| Hard silicone rubber | +2.5% | + 4.5% |

From the above results it can be seen that the developer composition of the present invention shows less tendency of damaging the rubber materials which are practically used for automatic developing machines.

Example 4

To a 4 wt.% cyclohexanone solution of a photosensitive polyester which had been prepared by condensing 1.0 mole of p-phenylenediacrylic acid with 0.35 moles of hydrogenated bisphenol A and 0.65 moles of triethylene glycol were added 1.8-dimethoxyanthraquinone and phthalocyanine pigment in amounts of 10 wt.% and 15 wt.% based on the polyester, respectively, to give a photosensitive solution. The photosensitive solution was coated on an electrolyzed aluminium plate having a thickness of 1.0—1.2 $\mu$. The thus obtained lithographic plate was dried, exposed through a negative film, and developed with a developer composition of the following formulation. The developing treatment was conducted by an automatic developing machine having a rubbing mechanism using a rotary brush roller.

| | |
|---|---|
| Ethylene glycol monophenyl ether | 50 wt.% |
| Tetrahydrofurfuryl alcohol | 40 wt.% |
| Diethylene glycol monomethyl ether | 5 wt.% |
| 85% Phosphoric acid | 3 wt.% |
| Water | 2 wt.% |

During the development, the treating speed of the automatic developing machine or the feed speed of the lithographic plate was varied from 0.5 m/min. to 2 m/min.; the image, e.g. a grey scale on the plate was found to show no change. The exposed, hardened image of the polymer composition on the plate was substantially free of swelling and suffered no damage, and the staining of the pigment of the non-image areas was not recognized. When the plate was used for printing, no stains on the non-image areas occurred and good printings were obtained.

Comparative Example 2

The lithographic plate of Example 4 was developed in the same manner as in Example 4 using a developer composition of the following formulation.

| | |
|---|---|
| $\gamma$-butyrolactone | 83 wt.% |
| Glycerine | 5 wt.% |
| $\gamma$-hydroxybutyric acid monoglyceride | 3 wt.% |
| $\gamma$-hydroxybutyric acid | 3 wt.% |

| | |
|---|---|
| p-Toluenesulfonic acid | 2 wt.% |
| Water | 4 wt.% |

The thus developed plate gave a good image and no stain on the non-image areas was found. However, when the feed speed of the plate in the automatic developing machine was varied from 0.5 m/min. to 2 m/min., the grey scale image formed on the plate was changed by one step in a maximum.

Example 5

The developer solution of the formulation of Example 4 was repeatedly used to develop the plate of the same type as in Example 1. That is, 200 $m^2$ of a non-exposed lithographic plate was developed but no depositing component was found in the developer solution, with the plate being cleanly developed without staining. Then, when the lithographic plate subjected to an image-wise exposure was developed with the repeatedly employed developer solution, the plate suffered from no stains and was formed with a good image thereon. The printing by using this plate resulted in good printings without involving any stains on the non-image areas.

**Claims**

1. A developer composition for a lithographic printing plate of the type which has a coating layer of a photosensitive polymer having in the main chain thereof a group represented by the general formula (I)

$$-(CX{=}CY)_n-\overset{\displaystyle O}{\overset{\|}{C}}-$$

(in which X and Y independently represent a hydrogen atom, a halogen atom, a cyano group or a nitro group, and n is an integer of 1 or 2)

comprising a mono-ether of ethylene glycol, an acid, water and optionally conventional additives and a poor solvent for adjusting the dissolving power of the composition

characterized by comprising

from 30 to 60 weight % of

ethylene glycol monophenyl ether as the ethylene glycol ether component

from 0.1 to 10 weight % of

at least one acid selected from the group consisting of mineral acids, organic carboxylic acids and organic sulfonic acids as the acid component

and less than 10 weight % of water in the developer composition, the balance being made up of the conventional additives and/or the poor solvent.

2. A developer composition according to claim 1, wherein the acid is phosphoric acid.

3. A developer composition according to claims 1—2, wherein at least one additive selected from a group consisting of wetting agents, surface active agents and oleophilic improvers is further container in the developer composition.

4. A developer composition according to claims 1—3, wherein a basic amine or salts thereof is further contained in the developer composition.

5. A developer composition according to claims 1—4, wherein a poor solvent is contained in the developer composition.

6. A developer composition according to claim 5, wherein the amount of the poor solvent is in the range of 30—70 weight % of the developer composition.

7. A developer composition according to claim 5 or 6, wherein the poor solvent is at least one selected from a group consisting of ethylene glycol monoalkyl ethers, diethylene glycol monoalkyl ethers, diethylene glycol monoalkyl ethers, diethylene glycol monoalkyl ether acetates and tetrahydrofurfuryl alcohol.

**Revendications**

1. Composition de révélateur pour une plaque d'impression lithographique du type comportant une couche de revêtement d'un polymère photosensible possédant dans sa chaîne principale un groupe représenté par la formule générale (I)

$$-(CX{=}CY)_n-\overset{\displaystyle O}{\overset{\|}{C}}-$$

dans laquelle X et Y représentent indépendamment an atome d'hydrogène, un atome d'halogène, un groupe cyano ou un groupe nitro et n'est un nombre entier 1 ou 2) comprenant un monoéther d'éthylèneglycol, un acide, de l'eau et facultativement des additifs classiques et un solvant médiocre pour l'ajustement du pouvoir dissolvant de la composition, caractérisée en ce qu'elle comprend 30 à 60% en poids d'éther monophénylique d'éthylèneglycol en tant que composant à base d'éthylèneglycol, 0,1 à 10% en poids d'au moins un acide choisi dans le groupe consistant en acides minéraux, acides carboxyliques organiques et acides organiques sulfoniques en tant que composant acide et moins de 10% en poids d'eau dans la composition de révélateur, le reliquat étant constitué par les additifs classiques et/ou le solvant médiocre.

2. Composition de révélateur selon la revendication 1, caractérisée en ce que l'acide est l'acide phosphorique.

3. Composition de révélateur selon l'une des revendications 1 ou 2, caractérisée en ce qu'au moins un additif choisi dans le groupe consistant en agents mouillants, agents tensioactifs et améliorateurs oléophiles est en outre contenu dans la composition de révélateur.

4. Composition de révélateur selon l'une quelconque des revendications 1 à 3, caractérisée en ce qu'une amine basique ou un de ses sels est en outre présente dans la composition de révélateur.

5. Composition de révélateur selon l'une quelconque des revendications 1 à 4, caractérisée en ce qu'un solvant médiocre est contenu dans la composition de révélateur.

6. Composition de révélateur selon la revendication 5, caractérisée en ce que la quantité de solvant médiocre se situe dans la gamme de 30 à 70% en poids de la composition de révélateur.

7. Composition de révélateur selon l'une des revendications 5 ou 6, caractérisée en ce que le solvant médiocre est au moins l'un de ceux choisi dans le groupe consistant en éthers monoalcoyliques d'éthylèneglycol, éthers monoalcoyliques de diéthylèneglycol, acétates d'éthers monoalcoyliques de diéthylèneglycol et en alcool tétrahydrofurfurylique.

**Patentansprüche**

1. Entwicklerzusammensetzung für eine lithographische Druckplatte von der Art, welche eine Beschichtungsschicht mit einem lichtempfindlichen Polymer aufweist, das in der Hauptkette eine Gruppe aufweist, die durch die folgende allgemeine Formel (I)

$$-(CX{=}CY)_n-\overset{\overset{\displaystyle O}{\|}}{C}-$$

dargestellt wird, (in welcher X und Y unabhängig voneinander ein Wasserstoffatom, ein Halogenatom, eine Cyan-gruppe oder eine Nitrogruppe bedeuten und n eine ganze Zahl von 1 oder 2 ist), die einen Mono-äther von Ethylenglykol, eine Säure, Wasser und gegebenenfalls herkömmliche Additive und ein schlecht lösendes Mittel zur Einstellung der Löslichkeitskraft der Zusammensetzung umfaßt, dadurch gekennzeichnet, daß diese umfaßt:

von 30 bis 60 Gew.-% Ethylenglykol-monophenyläther als die Ethylenglykoläther-Komponente,

von 0,1 bis 10 Gew.-% wenigstens einer Säure aus der Gruppe: Mineralsäuren, organischen Carbonsäuren und organischen Sulfonsäuren als die Säurekomponente, un weniger als 10 Gew.-% Wasser in der Entwicklerzusammensetzung, wobei der Rest durch herkömmliche Additive und/oder durch das schlecht lösende Mittel gebildet wird.

2. Entwicklerzusammensetzung nach Anspruch 1, worin die Säure Phosphorsäure ist.

3. Entwicklerzusammensetzung nach Anspruch 1—2, worin wenigstens ein Additiv, ausgewählt aus der Gruppe: Benetzungsmittel, oberflächenaktive Mittel, und oleophile Verbesserungsmittel zusätzlich in der Entwicklerzusammensetzung enthalten ist.

4. Entwicklerzusammensetzung nach Anspruch 1—3, worin ein basisches Amin oder ein Salz von diesem zusätzlich in der Entwicklerzusammensetzung enthalten ist.

5. Entwicklerzusammensetzung nach Anspruch 1—4, worin ein schlecht lösendes Mittel in der Entwicklerzusammensetzung enthalten ist.

6. Entwicklerzusammensetzung nach Anspruch 5, worin die Menge an schlecht lösendem Mittel im Bereich von 30—70 Gew.-% der Entwicklerzusammensetzung liegt.

7. Entwicklerzusammensetzung nach Anspruch 5 oder 6, worin das schlecht lösendes Mittel mindestens eines aus der Gruppe ist: Ethylenglycol-monoalkyläther, Diethylenglykol-monoalkyläther, Deithylenglykol-monoalkyläther, Diethylenglykol-monoalkylätheracetate und Tetrahydrofurfurylalkohol.